# EUROPEAN PATENT APPLICATION

(11) **EP 0 967 640 A2**
(43) Date of publication of application: **29.12.1999**
(21) Application number: 99304771.1
(22) Date of filing: 18.06.1999
(51) Int. Cl.: H01L 21/768, H01L 21/28

(54) **Method of making a self-aligned contact**

(30) Priority: 25.06.1998 US 105228
(71) Applicant: SIEMENS AKTIENGESELLSCHAFT, 80333 München (DE); International Business Machines Corporation, Armonk, NY 10504 (US)
(72) Inventor: Wittmann, Jürgen, Fishkill, NY 12524 (US); Spuler, Bruno, Wappingers Falls, NY 12590 (US); Dobuzinsky, Dave, Hopewell Junction, NY 12533 (US); Bergner, Wolfgang, Stormville, NV 12528 (US)
(74) Representative: Litchfield, Laura Marie

(57) **Abstract**

A method for improving the SAC process flow includes the deposition of an isolating spacer over the gate stacks after CB liner etch and the removal of previously performed nitride spacer deposition and etching. The isolating spacer is subsequently etched between the stacks to provide sufficient isolation of the bitline contacts from the inserted poly (contact). By depositing an isolating spacer after the typical CB nitride liner etch, additional integrity in the fabricated structures can be achieved.

## Description

The present invention related to semiconductor fabrication processes. More particularly, it relates to a method for improving the SAC process flow during semiconductor fabrication.

With the increasing desire to manufacture smaller semiconductor devices, many manufacturers use a self aligning technique. For example, the Self Aligned Contact (SAC) etching process for manufacturing semiconductor devices can decrease the area required to build a transistor. Generally, the SAC process includes the steps of inter alia, spacer Nitride deposition after the gate stack formation, and the spacer Nitride etch after the Nitride deposition. However, when manufacturing semiconductor devices using this process, electrical failures ("fails") are common. These electrical fails are referred to as CB shorts and CB opens.

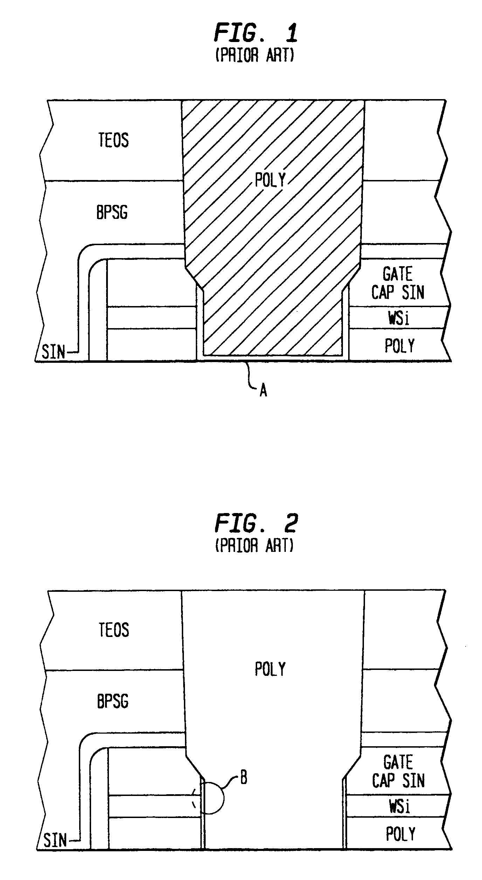

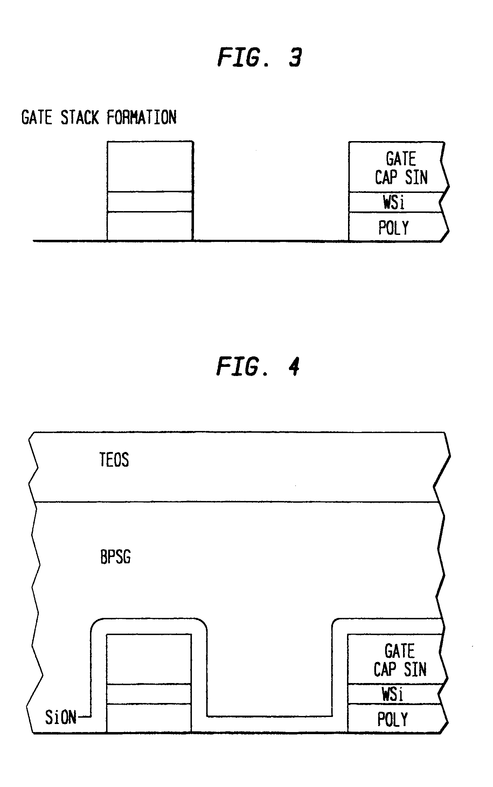

FIG. 1 shows an example of a CB open situation resulting from insufficient etching of the nitride layer. As such, a thin remaining nitride layer (Indicated by "A") prevents the poly from contacting the diffusion area, and results in an open circuit. CB opens can be caused by either incomplete SAC etch or CB liner etch In the case of the SAC etch, due to the CMP/BPSG nonuniformities across the wafer, a 40% overetch is necessary. As a result, FIG. 2 shows an example of a CB short situation, where the over etching of the nitride layer has caused it to be too thin, resulting in a short between the poly and WSi layer (indicated by "B").

Currently, the SAC etch process is performed in a TEL 85 DRM oxide chamber. The TEL tool has been the only tool leading to sufficient nitride corner selectivity (20:1), and thus to good electrical results. Other tools (e.g., AME MxP+) have demonstrated less comer selectivity and electrical fails.

In view of the foregoing, there is a need for a improving the SAC process to reduce, and possibly eliminate, the potential for CB opens and CB shorts during the semiconductor fabrication process.

It is therefore an object of the present invention to provide an improved SAC process which reduces the potential for electrical fails in the fabricated semiconductor device.

According to an embodiment of the present invention, the previously performed steps of spacer nitride deposition, and spacer nitride etching are removed from the SAC process, and additional steps of depositing an isolating spacer on the constructed transistor elements after the CB (bitline contact) nitride liner etch step, and subsequently etching the isolating spacer to provide sufficient isolation between the transistor parts while maintaining contact with the diffusion region. The isolating layer can be a nitride, oxide, or oxynitride layer.

A more complete appreciation of this invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is a schematic representation of an open caused during the prior art method of fabrication;
FIG. 2 is a schematic representation of a short caused during the prior art method of fabrication;
FIG. 3 is a schematic representation of a gate stack formation of the SAC process according to an embodiment of the present invention;
FIG. 4 is a schematic representation of the SiON, BPSG and TEOS deposition of the SAC process according to an embodiment of the present invention;
FIG. 5 is a schematic representation ofthe CB mask, SAC etch and liner etch of the SAC process according to an embodiment of the present invention;
FIG. 6 is a schematic representation of the spacer nitride deposition of the SAC process according to an embodiment of the present invention; and
FIG. 7 is a schematic representation of the spacer etch of the SAC process according to the present invention

Table 1 shows the contrast between a SAC process according to the present invention, and a standard SAC process (Status Janus). The steps of spacer Nitride deposition and spacer Nitride etch of the standard SAC process have been removed in the new process, and an alternative approach to these steps has been implemented after the CB nitride liner etch step.

**Table 1**

| | |
|---|---|
| Status Janus | SAC Method |
| Gate Stack Formation | Gate Stack Formation |
| Spacer Nitride deposition | |
| Spacer Nitride etch | |
| SiON liner deposition | SiON liner deposition |
| BPSG deposition / CMP | BPSG deposition / CMP |
| TEOS deposition/ anneal | TEOS deposition/ anneal |
| CB Mask | CB Mask |
| CB SAC etch | CB SAC etch |
| CB resist strip | CB resist strip |
| CB S/P clean | CB S/P clean |
| CB nitride liner etch | CB nitride liner etch |
| | Nitride / Oxide /Oxynitride dep |
| | Spacer etch |

The alternative approach deposits a nitride, oxide or oxynitride spacer layer after the CB (bitline contact) nitride liner etch, which acts as an isolating layer. The isolating nitride, oxide or oxynitride spacer layer is then etched to provide sufficient isolation from the transistor components, write providing contact with the diffusion region to prevent CB opens.

As shown in FIG. 3, the gate stack formation step of the SAC process is performed as usual on the Gate oxide layer (diffusion area). Subsequently, the SiN or SiON deposition over the gate stack is performed with the BPSG (Boro Phosphate Silicate Glass), and TEOS depositions following (FIG. 4). After the BPSG deposition, and before the TEOS deposition, a chemical mechanical polishing (CMP) is performed

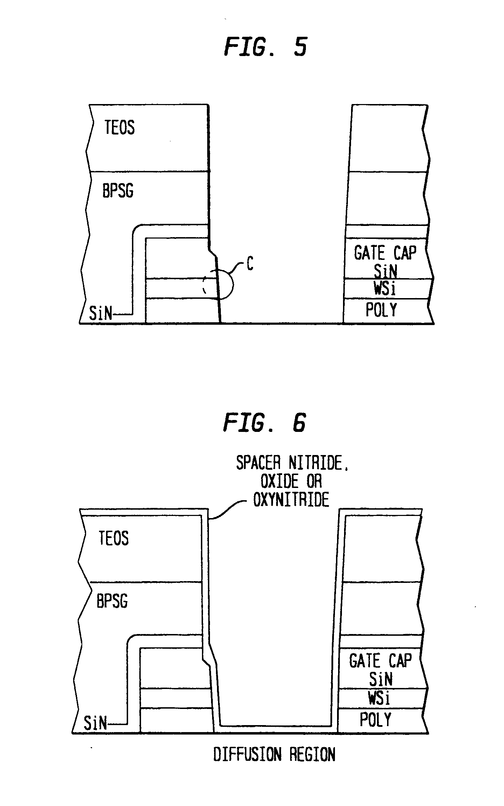

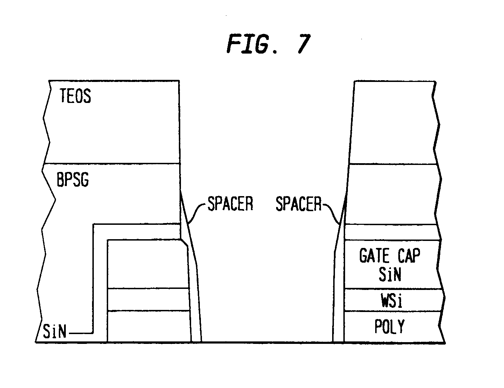

FIG. 5 shows the resulting structure after performing the next group of steps. Specifically, the CB Mask, SAC etch, resist strip, S/P clean, and liner etch. In the prior art method of fabrication, the nitride liner etch is an important step which can result in electrical fails (i.e., CB opens or CB shorts) depending on to little or too much etching. Since the spacer nitride deposition and etching is performed after the CB nitride liner etch (FIGS. 6 & 7), the nitride liner, in the worst case, can be totally etched (as indicated by "C" in FIG. 5), without having to be concerned with the potential CB short that ordinarily results from over etching.

FIG. 6 shows the spacer nitride, oxide or oxynitride deposition after the previous CB nitride liner etch step. The spacer nitride is preferable deposited using the plasma enhanced chemical vapor deposition (PECVD) technique because of its high aspect ratio in SAC structures. Subsequently, the spacer is dry etched to provide the structure depicted in FIG. 7. Dry etching provides the necessary anisotropy for the process. In order to avoid impacts on the device performance, the over etch into the silicon should be less than 30nm. As shown, the spacer has been etched to provide contact with the diffusion region insulting in the elimination of possible CB opens, and maintains the spacing with the etched SiN, Gate Cap SiN, Wsi, and Poly layers to prevent CB shorts. As shown, the nitride spacer acts as an isolating spacer that isolates the respective layers from the central poly layer and diffusion region.

It should be understood that the present invention is not limited to the particular embodiment disclosed herein as the best mode contemplated for carrying out the present invention, but rather that the present invention is not limited to the specific embodiments described in this specification except as defined in the appended claims.

## Claims

1. A method for improving the Self Aligning Contact (SAC) process during semiconductor fabrication comprising the steps of
depositing an isolating layer over a gate stack formed during fabrication; and
etching the isolating layer to form a spacer which isolates the gate stack from a contact region.

2. The method as claimed in claim 1, wherein the deposited isolating layer is one selected from a group consisting of a nitride layer, oxide layer, and an oxynitride layer.

3. The method as claimed in claim 1, wherein said step of depositing is performed after a step of CB nitride liner etching is performed.

4. The method as claimed in claim 1, wherein said step of depositing is performed using a plasma enhanced chemical vapor deposition technique.

5. A method for improving a standard Self Aligning Contact (SAC) semiconductor fabrication process comprising the steps of :
removing steps of spacer nitride deposition and spacer nitride etching from the standard SAC process, said removed steps of spacer nitride deposition and etching being performed after forming a gate stack;
depositing an isolating layer over the formed gate stack after a step of CB nitride liner etching in the standard process is performed; and
etching the isolating layer to form a spacer which isolates the gate stack from a contact region.

6. The method as claimed in claim 5, wherein the deposited isolating layer is one selected from a group consisting ofa nitride layer, oxide layer, and an oxynitride layer.

7. The method as claimed in claim 5, wherein said step of depositing an isolating layer is performed using a plasma enhanced chemical vapor deposition technique.

8. A method for Self Aligning Contact (SAC) semiconductor fabrication comprising the steps of:
forming a gate stack on a substrate;
depositing a liner over the formed gate stack;
depositing a BPSG layer over the liner;
depositing a TEOS layer over the BPSG layer;
masking bitline contacts;
SAC etching the bitline contacts;
resist stripping the bitline contacts;
cleaning the bitline contacts;
etching the liner for bitline contact;
depositing an isolating layer over the semiconductor device after said step of etching the liner; and
etching the isolating layer to form a spacer which isolates the gate stack from a contact region.

9. The method as claimed in claim 8, wherein the deposited isolating layer is one selected from a group consisting ofa nitride layer, oxide layer, and an oxynitride layer.

10. The method as claimed in claim 8, further comprising the step of chemical mechanical polishing the deposited BPSG layer prior to said step of depositing the TEOS layer.

11. The method as claimed in claim 8, wherein said step of depositing an isolating layer is performed using a plasma enhanced chemical vapor deposition technique.
